# EUROPEAN PATENT SPECIFICATION

(11) **EP 3 508 890 B1**
(45) Date of publication and mention of the grant of the patent: **19.04.2023**
(21) Application number: 17843342.1
(22) Date of filing: 02.08.2017
(51) Int. Cl.: C03C 14/00, C03C 8/14, C03B 19/06, G02B 5/20, H01L 33/50, C03C 3/16, C09K 11/08, C09K 11/02

(54) **METHOD FOR MANUFACTURING WAVELENGTH CONVERSION MEMBER**
VERFAHREN ZUR HERSTELLUNG EINES WELLENLÄNGENUMWANDLUNGSELEMENTS
PROCÉDÉ DE FABRICATION D'ÉLÉMENT DE CONVERSION DE LONGUEUR D'ONDE

(30) Priority: 23.08.2016 JP 2016162413
(43) Date of publication of application: 10.07.2019
(73) Proprietor: Nippon Electric Glass Co., Ltd., Otsu-shi, Shiga 520-8639 (JP)
(72) Inventor: SHIMIZU, Hiroyuki, Otsu-shi Shiga 520-8639 (JP); ASANO, Hideki, Otsu-shi Shiga 520-8639 (JP); MURATA, Takashi, Otsu-shi Shiga 520-8639 (JP)
(74) Representative: Tetzner, Michael
(86) International application number: PCT/JP2017/027966
(87) International publication number: WO 2018/037856

(56) References cited:
- WO-A1-2013/058065
- JP-A- S57 136 396
- JP-A- 2007 182 529
- JP-A- 2013 138 216
- JP-A- 2015 147 705
- JP-A- 2016 115 877

## Description

### [Technical Field]

The present invention relates to methods for manufacturing wavelength conversion members that convert the wavelength of light emitted from a light emitting diode (LED), a laser diode (LD) or the like to another wavelength.

### [Background Art]

Recently, attention has been increasingly focused on light emitting devices and the like using LEDs or LDs, as next-generation light sources to replace fluorescence lamps and incandescent lamps. As an example of such a next-generation light source, there is a disclosure of a light emitting device in which an LED for emitting a blue light is combined with a wavelength conversion member capable of absorbing part of the light from the LED to convert it to a yellow light. This light emitting device emits a white light which is a synthesized light of the blue light emitted from the LED and the yellow light emitted from the wavelength conversion member. JP 2003 258308 A proposes, as an example of a wavelength conversion member, a wavelength conversion member in which phosphor particles are dispersed in a glass matrix.

JP 2007 182529 A discloses, as a method for manufacturing a wavelength conversion member having a large size and a small and uniform thickness, a manufacturing method based on the green sheet method.

### [Summary of Invention]

### [Technical Problem]

In such a manufacturing method based on the green sheet method as described above, obtained wavelength conversion members often have unevenness in luminescent color.

An object of the present invention is to provide a method for manufacturing a wavelength conversion member by which unevenness in luminescent color are less likely to occur.

### [Solution to Problem]

A method for manufacturing a wavelength conversion member according to the present invention is a method for manufacturing a wavelength conversion member including phosphor particles disposed in a glass matrix and includes the steps of: preparing a slurry containing glass particles to be the glass matrix and the phosphor particles; forming a green sheet by applying the slurry onto a support substrate and moving a doctor blade relative to the slurry, the doctor blade being spaced a predetermined distance away from the support substrate; forming a green sheet laminate by applying heat and pressure to a plurality of the green sheets overlaid one upon another; and sintering the green sheet laminate to obtain a wavelength conversion member, wherein in the step of forming a green sheet laminate, the plurality of green sheets are overlaid one upon another so that, as for at least two of the plurality of green sheets, respective directions of movement of the doctor blade in the step of forming a green sheet are substantially perpendicular to each other.

In the method for manufacturing a wavelength conversion member according to the present invention, preferably, the step of forming a green sheet laminate is the step of repeatedly and alternately overlaying first and second green sheets one upon another to form the green sheet laminate, and in overlaying the first and second green sheets one upon another, the first and second green sheets are overlaid one upon another so that the respective directions of movement of the doctor blade in the step of forming each of the first and second green sheets are substantially perpendicular to each other.

In the method for manufacturing a wavelength conversion member according to the present invention, preferably, in overlaying the green sheets one upon another, three or more green sheets are overlaid one upon another.

### [Advantageous Effects of Invention]

The present invention enables provision of a method for manufacturing a wavelength conversion member by which unevenness in luminescent color are less likely to occur.

### [Brief Description of Drawings]

[Fig. 1] Fig. 1 is a schematic cross-sectional view showing a wavelength conversion member manufactured by a method for manufacturing a wavelength conversion member according to one embodiment of the present invention.
[Fig. 2] Fig. 2 is a schematic perspective view for illustrating how to overlay green sheets one upon another in the method for manufacturing a wavelength conversion member according to the one embodiment of the present invention.
[Fig. 3] Fig. 3 is a schematic perspective view for illustrating how to overlay green sheets one upon another in a method for manufacturing a wavelength conversion member according to a comparative example.

### [Description of Embodiments]

Hereinafter, a description will be given of a preferred embodiment. However, the following embodiment is merely illustrative and the present invention is not limited to the following embodiment. Throughout the drawings, members having substantially the same functions may be referred to by the same reference characters.

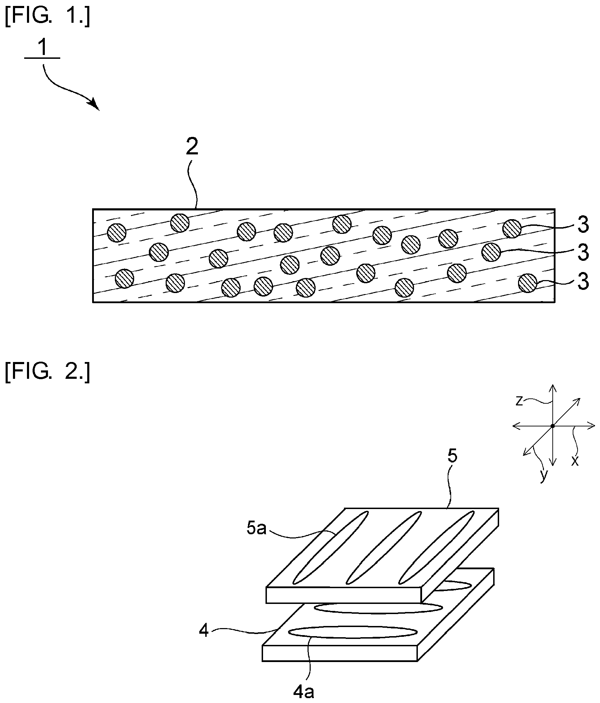

Fig. 1 is a schematic cross-sectional view showing a wavelength conversion member manufactured by a method for manufacturing a wavelength conversion member according to one embodiment of the present invention. As shown in Fig. 1, a wavelength conversion member 1 is made of a phosphor glass that contains a glass matrix 2 and phosphor particles 3. The phosphor particles 3 are disposed in the glass matrix 2. More specifically, the phosphor particles 3 are dispersed in the glass matrix 2. The wavelength conversion member 1 has, for example, a rectangular plate shape.

In the wavelength conversion member 1 according to this embodiment, for example, excitation light enters the wavelength conversion member 1 through one principal surface thereof, and a synthesized light of the excitation light and fluorescence emitted from the phosphor particles 3 exits the wavelength conversion member 1 through the other principal surface thereof.

No particular limitation is placed on the type of glass forming the glass matrix 2 so long as it can be used as a dispersion medium for the phosphor particles 3, such as inorganic phosphor. For example, borosilicate glass, phosphate glass, tin-phosphate glass or bismuthate glass can be used. Examples of the borosilicate glass include those containing, in % by mass, 30 to 85% SiO₂, 0 to 30% Al₂O₃, 0 to 50% B₂O₃, 0 to 10% Li₂O+Na₂O+K₂O, and 0 to 50% MgO+CaO+SrO+BaO. Examples of the tin-phosphate glass include those containing, in % by mole, 30 to 90% SnO and 1 to 70% P₂O₅.

The softening point of the glass matrix 2 is preferably 250°C to 1000°C, more preferably 300°C to 950°C, and still more preferably in a range of 500°C to 900°C. If the softening point of the glass matrix 2 is too low, the mechanical strength and chemical durability of the wavelength conversion member 1 may decrease. Furthermore, because the thermal resistance of the glass matrix 2 itself is low, the wavelength conversion member 1 may be softened and deformed by heat generated by the phosphor particles 3. On the other hand, if the softening point of the glass matrix 2 is too high, the phosphor particles 3 may be deteriorated in the step of sintering a green sheet laminate, so that the luminescence intensity of the wavelength conversion member 1 may decrease. From the viewpoint of further increasing the chemical stability and mechanical strength of the wavelength conversion member 1, the softening point of the glass matrix 2 is preferably not less than 500°C, more preferably not less than 600°C, still more preferably not less than 700°C, yet still more preferably not less than 800°C, and particularly preferably not less than 850°C. An example of such a glass is borosilicate glass. However, if the softening point of the glass matrix 2 rises, the firing temperature also rises and, as a result, the production cost tends to rise. Therefore, from the viewpoint of more inexpensively manufacturing the wavelength conversion member 1, the softening point of the glass matrix 2 is preferably not more than 550°C, more preferably not more than 530°C, still more preferably not more than 500°C, yet still more preferably not more than 480°C, and particularly preferably not more than 460°C. Examples of such a glass include tin-phosphate glass and bismuthate glass.

No particular limitation is placed on the type of the phosphor particles 3 so long as they emit fluorescence upon entry of excitation light. A specific example of the type of the phosphor particles 3 is one or more selected from the group consisting of oxide phosphor, nitride phosphor, oxynitride phosphor, chloride phosphor, oxychloride phosphor, sulfide phosphor, oxysulfide phosphor, halide phosphor, chalcogenide phosphor, aluminate phosphor, halophosphoric acid chloride phosphor, and garnet-based compound phosphor. When using a blue light as the excitation light, for example, a phosphor emitting a green light, a yellow light or a red light as fluorescence can be used.

The average particle diameter of the phosphor particles 3 is preferably 1 µm to 50 µm and more preferably 5 µm to 25 µm. If the average particle diameter of the phosphor particles 3 is too small, the luminescence intensity may decrease. On the other hand, if the average particle diameter of the phosphor particles 3 is too large, the luminescent color may be uneven.

The content of phosphor particles 3 in the wavelength conversion member 1 is preferably not less than 1% by volume, more preferably not less than 1.5% by volume, particularly preferably not less than 2% by volume, preferably not more than 70% by volume, more preferably not more than 50% by volume, and particularly preferably not more than 30% by volume. If the content of phosphor particles 3 is too small, the luminescence intensity may decrease. On the other hand, if the content of phosphor particles 3 is too large, the luminescent color may be uneven.

The thickness of the wavelength conversion member 1 is preferably not less than 0.01 mm, more preferably not less than 0.03 mm, still more preferably not less than 0.05 mm, yet still more preferably not less than 0.075 mm, and particularly preferably not less than 0.1 mm, preferably not more than 1 mm, more preferably not more than 0.5 mm, still more preferably not more than 0.35 mm, yet still more preferably not more than 0.3 mm, and particularly preferably not more than 0.25 mm. If the thickness of the wavelength conversion member 1 is too large, scattering and absorption of light in the wavelength conversion member 1 may become too much, so that the efficiency of emission of fluorescence may become low. If the thickness of the wavelength conversion member 1 is too small, sufficient luminescence intensity may be less likely to be obtained. In addition, the mechanical strength of the wavelength conversion member 1 may be insufficient.

A description will be given below of an example of a method for manufacturing a wavelength conversion member 1.

### (Method for Manufacturing Wavelength Conversion Member)

In the method for manufacturing the wavelength conversion member 1, first, a slurry is prepared which contains glass particles to be a glass matrix 2 and phosphor particles 3. The slurry normally contains a binder resin and a solvent.

Subsequently, the prepared slurry is applied onto a support substrate and a doctor blade spaced a predetermined distance away from the support substrate is moved relative to the slurry to form a green sheet. The formed green sheet is cut into a plurality of green sheets. For example, a resin film made of polyethylene terephthalate or other resins can be used as the support substrate.

Next, heat and pressure are applied to the plurality of prepared green sheets overlaid one upon another to form a green sheet laminate. In the manufacturing method according to this embodiment, the plurality of green sheets are overlaid one upon another so that, as for at least two of the plurality of green sheets, the respective directions of movement of the doctor blade (the directions of formation of the green sheets) in the step of forming the green sheet intersect each other.

No particular limitation is placed on the temperature during the application of heat and pressure, but it is preferably not less than 30°C, more preferably not less than 60°C, preferably not more than 170°C, and more preferably not more than 140°C. If the temperature during the application of heat and pressure is too low, glass transition of the binder resin may not occur sufficiently, so that an adhesion failure may occur between the green sheets. If the temperature during the application of heat and pressure is too high, the fluidity of the green sheets may become too high, so that the green sheets may be deformed.

No particular limitation is placed on the pressure during the application of heat and pressure, but it is preferably not less than 0.1 MPa, more preferably not less than 1 MPa, preferably not more than 60 MPa, and more preferably not more than 30 MPa. If the pressure during the application of heat and pressure is too low, the adhesion between the green sheets may become weak, so that a delamination may occur after sintering. If the pressure during the application of heat and pressure is too high, the green sheet may be deformed.

Furthermore, in overlaying the plurality of green sheets one upon another, three or more green sheets are preferably overlaid one upon another. In this case, the obtained wavelength conversion member 1 is even less likely to have unevenness in luminescent color. In addition, the mechanical strength of the obtained wavelength conversion member 1 can be further increased. No particular limitation is placed on the upper limit of the number of green sheets overlaid, but it is generally not more than ten and preferably not more than six.

Next, the green sheet laminate is sintered. Thus, a wavelength conversion member 1 can be obtained. The sintering temperature for the green sheet laminate is, for example, preferably in a range of the softening point of the glass particles to the softening point of the glass particles plus about 100°C. If the sintering temperature for the green sheet laminate is too low, a dense sintered body becomes less likely to be obtained, so that the wavelength conversion member 1 tends to have poor mechanical strength. On the other hand, if the sintering temperature for the green sheet laminate is too high, the phosphor particles 3, if having low thermal resistance, may be thermally deteriorated, so that the luminescence intensity may decrease.

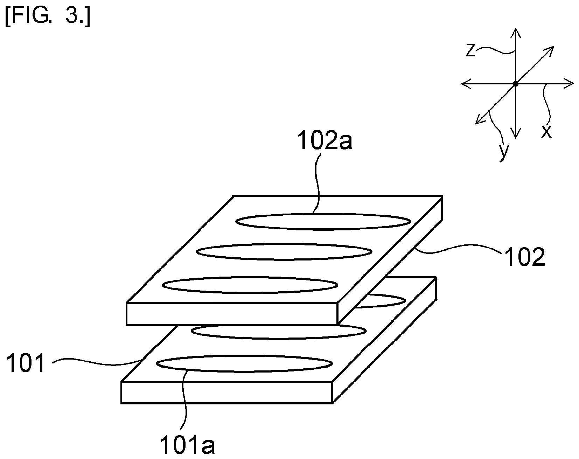

As described previously, in the manufacturing method according to this embodiment, in overlaying a plurality of green sheets one upon another, the plurality of green sheets are overlaid one upon another so that, as for at least two of the plurality of green sheets, the respective directions of movement of the doctor blade in the step of forming the green sheet are substantially perpendicular to each other. Therefore, the obtained wavelength conversion member 1 can be made less likely to have unevenness in luminescent color. This will be described below in more detail with reference to Figs. 2 and 3.

Fig. 2 is a schematic perspective view for illustrating how to overlay green sheets one upon another in the method for manufacturing a wavelength conversion member according to the one embodiment of the present invention. Furthermore, Fig. 3 is a schematic perspective view for illustrating how to overlay green sheets one upon another in a method for manufacturing a wavelength conversion member according to a comparative example.

As shown in Fig. 3, in a manufacturing method according to a comparative example, first and second green sheets 101, 102 are overlaid one upon another so that the respective directions of movement of the doctor blade in the step of forming the green sheet are the same direction x.

In a method for forming a green sheet based on the doctor blade method, such stripes 101a, 102a as shown in Fig. 3 tend to form along the direction of movement of the doctor blade (the direction of formation of a green sheet) . The stripes 101a, 102a are portions formed linearly in the direction of movement of the doctor blade and having a relatively high (or low) phosphor concentration. As shown in Fig. 3, in the manufacturing method according to the comparative example, the stripes 101a on the first green sheet 101 and the stripes 102a on the second green sheet 102 are oriented substantially in the same direction in plan view. Thus, the phosphor concentration in the portions provided with the stripes 101a, 102a becomes even higher (or smaller) as compared to that in the surrounding portions. Therefore, a wavelength conversion member obtained by the manufacturing method according to the comparative example is likely to have unevenness in luminescent color.

Unlike the above, in the manufacturing method according to this embodiment, the first and second green sheets 4, 5 are overlaid one upon another so that the direction of movement of the doctor blade for the first green sheet 4 and the direction of movement of the doctor blade for the second green sheet 5 are substantially perpendicular to each other. More specifically, as shown in Fig. 2, the overlaying is performed so that the direction of movement of the doctor blade for the first green sheet 4 is the direction x. At the same time, the overlaying is performed so that the direction of movement of the doctor blade for the second green sheet 5 is the direction y. Thus, stripes 4a on the first green sheet 4 and stripes 5a on the second green sheet 5 are overlapped to intersect one another substantially perpendicularly in plan view. Therefore, a wavelength conversion member 1 obtained by the manufacturing method according to this embodiment is less likely to have unevenness in luminescent color.

In the manufacturing method according to this embodiment, a green sheet laminate is formed in such a manner that, as described above, in overlaying a plurality of green sheets one upon another, as for at least two of the plurality of green sheets, these green sheets are overlaid so that the respective directions of movement of the doctor blade in the step of forming the green sheet are substantially perpendicular to each other.

However, in the present invention, like the first and second green sheets 4, 5 shown in Fig. 2, a green sheet laminate may be formed by repeatedly and alternately overlaying two types of green sheets having different directions of movement of the doctor blade in the step of forming the green sheet. By doing so, the unevenness in luminescent color can be further prevented.

Furthermore, in overlaying the first and second green sheets 4, 5 one upon another, these green sheets are overlaid so that the direction y of movement of the doctor blade for the second green sheet 5 is substantially perpendicular to the direction x of movement of the doctor blade for the first green sheet 4. By overlaying them one upon another in this manner, the unevenness in luminescent color can be still further prevented.

### [Reference Signs List]

- 1: wavelength conversion member
- 2: glass matrix
- 3: phosphor particle
- 4, 5: first and second green sheets
- 4a, 5a: stripe

## Claims

1. A method for manufacturing a wavelength conversion member (1) including phosphor particles (3) disposed in a glass matrix (2), the method comprising the steps of:
preparing a slurry containing glass particles to be the glass matrix (2) and the phosphor particles (3);
forming a green sheet (4, 5) by applying the slurry onto a support substrate and moving a doctor blade relative to the slurry, the doctor blade being spaced a predetermined distance away from the support substrate;
forming a green sheet laminate by applying heat and pressure to a plurality of the green sheets (4, 5) overlaid one upon another; and
sintering the green sheet laminate to obtain a wavelength conversion member (1),
wherein in the step of forming a green sheet laminate, the plurality of green sheets (4, 5) are overlaid one upon another so that, as for at least two of the plurality of green sheets (4, 5), respective directions of movement of the doctor blade in the step of forming a green sheet are substantially perpendicular to each other.

2. The method for manufacturing a wavelength conversion member (1) according to claim 1, wherein
the step of forming a green sheet laminate is the step of repeatedly and alternately overlaying first and second green sheets (4, 5) one upon another to form the green sheet laminate, and
in overlaying the first and second green sheets one upon another, the first and second green sheets (4, 5) are overlaid one upon another so that the respective directions of movement of the doctor blade in the step of forming each of the first and second green sheets are substantially perpendicular to each other.

3. The method for manufacturing a wavelength conversion member (1) according to claim 1 or 2, wherein in overlaying the green sheets (4, 5) one upon another, three or more green sheets (4, 5) are overlaid one upon another.

4. The method for manufacturing a wavelength conversion member (1) according to any one of claims 1 to 3, wherein in overlaying the green sheets (4, 5) one upon another, not more than ten green sheets (4, 5) are overlaid one upon another.

5. The method for manufacturing a wavelength conversion member (1) according to any one of claims 1 to 4, wherein the glass forming the glass matrix (2) is borosilicate glass, phosphate glass, tin-phosphate glass or bismuthate glass.

6. The method for manufacturing a wavelength conversion member (1) according to any one of claims 1 to 5, wherein the glass forming the glass matrix (2) contains, in % by mass, 30 to 85% SiO₂, 0 to 30% Al₂O₃, 0 to 50% B₂O₃, 0 to 10% Li₂O+Na₂O+K₂O, and 0 to 50% MgO+CaO+SrO+BaO.

7. The method for manufacturing a wavelength conversion member (1) according to any one of claims 1 to 6, wherein the softening point of the glass matrix (2) is 250°C to 1000°C.

8. The method for manufacturing a wavelength conversion member (1) according to any one of claims 1 to 7, wherein the phosphor particles (3) is one or more selected from the group consisting of oxide phosphor, nitride phosphor, oxynitride phosphor, chloride phosphor, oxychloride phosphor, sulfide phosphor, oxysulfide phosphor, halide phosphor, chalcogenide phosphor, aluminate phosphor, halophosphoric acid chloride phosphor, and garnet-based compound phosphor.

9. The method for manufacturing a wavelength conversion member (1) according to any one of claims 1 to 8, wherein the average particle diameter of the phosphor particles (3) is 1 µm to 50 µm.

10. The method for manufacturing a wavelength conversion member (1) according to any one of claims 1 to 9, wherein the content of phosphor particles (3) in the wavelength conversion member is not less than 1% by volume and not more than 70% by volume.

11. The method for manufacturing a wavelength conversion member (1) according to any one of claims 1 to 10, wherein the temperature during the application of heat and pressure to the green sheet (4, 5) is not less than 30°C and not more than 170°C.

12. The method for manufacturing a wavelength conversion member (1) according to any one of claims 1 to 11, wherein the pressure during the application of heat and pressure to the green sheet (4, 5) is not less than 0.1 MPa and not more than 60 MPa.

13. The method for manufacturing a wavelength conversion member (1) according to any one of claims 1 to 12, wherein the sintering temperature for the green sheet laminate is in a range of the softening point of the glass particles to the softening point of the glass particles plus 100°C.

## Patentansprüche

1. Verfahren zum Herstellen eines Wellenlängen-Umwandlungselements (1), das Leuchtstoff-Partikel (3) enthält, die in einer Glasmatrix (2) angeordnet sind, das Verfahren umfassend die folgenden Schritte:
Herstellen einer Aufschlämmung, die Glaspartikel, die die Glasmatrix (2) bilden sollen, und die Leuchtstoff-Partikel (3) enthält,
Ausbilden einer Grünfolie (4, 5) durch Auftragen der Aufschlämmung auf ein Trägersubstrat und Bewegen einer Rakel relativ zu der Aufschlämmung, wobei die Rakel in einem vorgegebenen Abstand von dem Trägersubstrat beabstandet ist,
Ausbilden eines Grünfolienlaminats durch Anwenden von Wärme und Druck auf eine Vielzahl der Grünfolien (4, 5), die eine über die andere gelegt sind, und
Sintern des Grünfolienlaminats, um ein Wellenlängen-Umwandlungselement (1) zu erhalten,
wobei beim Schritt des Ausbildens eines Grünfolienlaminats die Vielzahl von Grünfolien (4, 5) eine über die andere gelegt sind, so dass für mindestens zwei aus der Vielzahl von Grünfolien (4, 5) entsprechende Bewegungsrichtungen der Rakel beim Schritt des Ausbildens einer Grünfolie im Wesentlichen senkrecht zueinander sind.

2. Verfahren zum Herstellen eines Wellenlängen-Umwandlungselements (1) nach Anspruch 1, wobei
der Schritt des Ausbildens eines Grünfolienlaminats der Schritt des wiederholten und abwechselnden Übereinanderlegens erster und zweiter Grünfolien (4, 5) eine über die andere zur Bildung des Grünfolienlaminats ist und
beim Überlagern der ersten und zweiten Grünfolien eine über die andere, die ersten und zweiten Grünfolien (4, 5) eine über die andere gelegt werden, so dass die jeweiligen Bewegungsrichtungen der Rakel in dem Schritt des Ausbildens jeder der ersten und zweiten Grünfolien im Wesentlichen senkrecht zueinander sind.

3. Verfahren zum Herstellen eines Wellenlängen-Umwandlungselements (1) nach Anspruch 1 oder 2, wobei beim Überlagern der Grünfolien (4, 5) eine über die andere drei oder mehr Grünfolien (4, 5) übereinandergelegt werden.

4. Verfahren zum Herstellen eines Wellenlängen-Umwandlungselements (1) nach einem der Ansprüche 1 bis 3, wobei beim Überlagern der Grünfolien (4, 5) eine über die andere nicht mehr als zehn Grünfolien (4, 5) übereinandergelegt werden.

5. Verfahren zum Herstellen eines Wellenlängen-Umwandlungselements (1) nach einem der Ansprüche 1 bis 4, wobei das Glas, das die Glasmatrix (2) bildet, Borosilikatglas, Phosphatglas, Zinnphoshpatglas oder Bimuthatglas ist.

6. Verfahren zum Herstellen eines Wellenlängen-Umwandlungselements (1) nach einem der Ansprüche 1 bis 5, wobei das Glas, das die Glasmatrix (2) bildet, in Massenprozent 30 bis 85 % SiO₂, 0 bis 30 % Al₂O₃, 0 bis 50 % B₂O₃, 0 bis 10 % Li₂O+Na₂O+K₂O und 0 bis 50 % MgO+CaO+SrO+BaO enthält.

7. Verfahren zum Herstellen eines Wellenlängen-Umwandlungselements (1) nach einem der Ansprüche 1 bis 6, wobei der Erweichungspunkt der Glasmatrix (2) 250 °C bis 1000 °C beträgt.

8. Verfahren zum Herstellen eines Wellenlängen-Umwandlungselements (1) nach einem der Ansprüche 1 bis 7, wobei die Leuchtstoff-Partikel (3) eines oder mehrere sind, die aus der Gruppe ausgewählt sind, die aus Oxid-Leuchtstoff, Nitrid-Leuchtstoff, Oxynitrid-Leuchtstoff, Chlorid-Leuchtstoff, Oxychlorid-Leuchtstoff, Sulfid-Leuchtstoff, Oxysulfid-Leuchtstoff, Halogenid-Leuchtstoff, Chalcogenid-Leuchtstoff, Aluminat-Leuchtstoff, Halophosphorsäurechlorid-Leuchtstoff und auf Granatverbindungen basierender Leuchtstoff besteht.

9. Verfahren zum Herstellen eines Wellenlängen-Umwandlungselements (1) nach einem der Ansprüche 1 bis 8, wobei der mittlere Partikeldurchmesser (3) der Leuchtstoff-Partikel 1 µm bis 50 µm beträgt.

10. Verfahren zum Herstellen eines Wellenlängen-Umwandlungselements (1) nach einem der Ansprüche 1 bis 9, wobei der Gehalt an Leuchtstoff-Partikeln (3) im Wellenlängen-Umwandlungselement nicht weniger als 1 Volumenprozent und nicht mehr als 70 Volumenprozent beträgt.

11. Verfahren zum Herstellen eines Wellenlängen-Umwandlungselements (1) nach einem der Ansprüche 1 bis 10, wobei die Temperatur während der Anwendung von Wärme und Druck auf die Grünfolie (4, 5) nicht weniger als 30 °C und nicht mehr als 170 °C beträgt.

12. Verfahren zum Herstellen eines Wellenlängen-Umwandlungselements (1) nach einem der Ansprüche 1 bis 11, wobei der Druck während der Anwendung von Wärme und Druck auf die Grünfolie (4, 5) nicht weniger als 0,1 MPa und nicht mehr als 60 MPa beträgt.

13. Verfahren zum Herstellen eines Wellenlängen-Umwandlungselements (1) nach einem der Ansprüche 1 bis 12, wobei die Sintertemperatur für das Grünfolienlaminat in einem Bereich des Erweichungspunkts der Glaspartikel zum Erweichungspunkt der Glaspartikel plus 100 °C liegt.

## Revendications

1. Procédé de fabrication d'un élément de conversion de longueur d'onde (1) comprenant des particules de phosphore (3) disposées dans une matrice de verre (2), le procédé comprenant les étapes consistant :
à préparer une pâte contenant des particules de verre devant être la matrice de verre (2) et les particules de phosphore (3) ;
à former une feuille verte (4, 5), en appliquant la pâte sur un substrat support et en déplaçant un racloir par rapport à la pâte, le racloir étant espacé d'une distance prédéterminée par rapport au substrat support ;
à former un stratifié de feuilles vertes, en appliquant de la chaleur et de la pression sur une pluralité des feuilles vertes (4, 5) superposées les unes sur les autres ; et
à fritter le stratifié de feuilles vertes afin d'obtenir un élément de conversion de longueur d'onde (1),
procédé dans lequel, au cours de l'étape de formation d'un stratifié de feuilles vertes, les feuilles vertes (4, 5) formant une pluralité de feuilles sont superposées les unes sur les autres, de sorte que, comme pour au moins deux feuilles parmi la pluralité de feuilles vertes (4, 5), des directions respectives de mouvement du racloir, au cours de l'étape de formation d'une feuille verte, sont pratiquement perpendiculaires l'une par rapport à l'autre.

2. Procédé de fabrication d'un élément de conversion de longueur d'onde (1) selon la revendication 1, procédé dans lequel :
l'étape de formation d'un stratifié de feuilles vertes est l'étape de superposition l'une sur l'autre, effectuée de façon répétée et alternée, des première et seconde feuilles vertes (4, 5), afin de former le stratifié de feuilles vertes, et
en superposant les première et seconde feuilles vertes l'une sur l'autre, les première et seconde feuilles vertes (4, 5) sont superposées l'une sur l'autre, de sorte que les directions respectives de mouvement du racloir, au cours de l'étape de formation de chacune des première et seconde feuilles vertes, sont pratiquement perpendiculaires l'une par rapport à l'autre.

3. Procédé de fabrication d'un élément de conversion de longueur d'onde (1) selon la revendication 1 ou 2, procédé dans lequel, en superposant les feuilles vertes (4, 5) l'une sur l'autre, trois ou plus feuilles vertes (4, 5) sont superposées les unes sur les autres.

4. Procédé de fabrication d'un élément de conversion de longueur d'onde (1) selon l'une quelconque des revendications 1 à 3, procédé dans lequel, en superposant les feuilles vertes (4, 5) l'une sur l'autre, pas plus de dix feuilles vertes (4, 5) sont superposées les unes sur les autres.

5. Procédé de fabrication d'un élément de conversion de longueur d'onde (1) selon l'une quelconque des revendications 1 à 4, procédé dans lequel le verre formant la matrice de verre (2) est du verre borosilicaté, du verre phosphaté, du verre de phosphate d'étain ou du verre de bismuthate.

6. Procédé de fabrication d'un élément de conversion de longueur d'onde (1) selon l'une quelconque des revendications 1 à 5, procédé dans lequel le verre formant la matrice de verre (2) contient, en % en masse, de 30 % à 85 % de SiO₂, de 0 % à 30 % de Al₂O₃, de 0 % à 50 % de B₂O₃, de 0 % à 10 % de Li₂O + Na₂O + K₂O et de 0 % à 50 % de MgO + CaO + SrO + BaO.

7. Procédé de fabrication d'un élément de conversion de longueur d'onde (1) selon l'une quelconque des revendications 1 à 6, procédé dans lequel le point de ramollissement de la matrice de verre (2) est compris entre 250°C et 1000°C.

8. Procédé de fabrication d'un élément de conversion de longueur d'onde (1) selon l'une quelconque des revendications 1 à 7, procédé dans lequel les particules de phosphore (3) sont une ou plusieurs particules sélectionnées parmi le groupe se composant d'un phosphore d'oxyde, d'un phosphore de nitrure, d'un phosphore d'oxynitrure, d'un phosphore de chlorure, d'un phosphore d'oxychlorure, d'un phosphore de sulfure, d'un phosphore d'oxysulfure, d'un phosphore d'halogénure, d'un phosphore de chalcogénure, d'un phosphore d'aluminate, d'un phosphore de chlorure d'acide halophosphorique et d'un phosphore d'un composé à base de grenat.

9. Procédé de fabrication d'un élément de conversion de longueur d'onde (1) selon l'une quelconque des revendications 1 à 8, procédé dans lequel le diamètre moyen des particules de phosphore (3) est compris entre 1 µm et 50 µm.

10. Procédé de fabrication d'un élément de conversion de longueur d'onde (1) selon l'une quelconque des revendications 1 à 9, procédé dans lequel la teneur en particules de phosphore (3), dans l'élément de conversion de longueur d'onde, n'est pas inférieure à 1 % en volume et pas supérieure à 70 % en volume.

11. Procédé de fabrication d'un élément de conversion de longueur d'onde (1) selon l'une quelconque des revendications 1 à 10, procédé dans lequel la température au cours de l'application de la chaleur et de la pression sur la feuille verte (4, 5) n'est pas inférieure à 30°C et pas supérieure à 170°C.

12. Procédé de fabrication d'un élément de conversion de longueur d'onde (1) selon l'une quelconque des revendications 1 à 11, procédé dans lequel la pression au cours de l'application de la chaleur et de la pression sur la feuille verte (4, 5) n'est pas inférieure à 0,1 MPa et pas supérieure à 60 MPa.

13. Procédé de fabrication d'un élément de conversion de longueur d'onde (1) selon l'une quelconque des revendications 1 à 12, procédé dans lequel la température de frittage pour le stratifié de feuilles vertes se situe dans une plage allant du point de ramollissement des particules de verre jusqu'au point de ramollissement des particules de verre plus 100°C.
